# EUROPEAN PATENT APPLICATION

(11) **EP 4 642 182 A1**
(43) Date of publication of application: **29.10.2025**
(21) Application number: 24171883.2
(22) Date of filing: 23.04.2024
(51) Int. Cl.: H05K 9/00

(54) **METHOD OF EMC TAPE-LIKE FEATURES APPLICATION IN UNITS HOUSINGS**

(71) Applicant: Aptiv Technologies AG, 8200 Schaffhausen (CH)
(72) Inventor: BARUS, Lukasz, 8200 Schaffhausen (CH); SWIERCZ, Karol, 8200 Schaffhausen (CH); KUPCZYK, Pawel, 8200 Schaffhausen (CH)
(74) Representative: Bardehle Pagenberg Partnerschaft mbB Patentanwälte Rechtsanwälte

(57) **Abstract**

The present disclosure relates to electromagnetic compatibility (EMC). A foam tape (100) is provided. The foam tape (100) is for providing EMC-shielding to electronic devices. The foam tape (100) comprises one or more elongated foam segments (102), each elongated foam segment (102) having a cross section (108) and a length (110). Each elongated foam segment (102) is compressible in at least a direction perpendicular to the length (110). Each elongated foam segment (102) is electrically conductive in at least a direction perpendicular to the length (110).

## Description

### 1. Field of the invention

The present disclosure generally relates to electromagnetic compatibility (EMC). More specifically, a foam tape for providing EMC-shielding to electronic devices and a method of application thereof are disclosed.

### 2. Prior art

In general, electric and/or magnetic field generated by an electronic device may be required to stay confined within it. Also, such fields may be required not to enter the device from outside. The rationale for the above requirements includes avoiding mutual interference among electronic devices and/or ensuring compliance with regulatory (or customer) specifications. In general, various measures are generally known to facilitate electromagnetic compatibility (EMC), for example, by shielding electric and/or magnetic fields. Such measures include the use of electrically conductive elements which effectuate electric contact between a printed circuit board and a housing of an electronic device or between two parts of the housing with each other. Known elements used for EMC-shielding include grounding springs, die-cut cubical or surface mount device (SMD) foams, form-in-place (FIP) gaskets, contact dimples, or the like. Many such elements and respective methods of application thereof generally involve various disadvantages, for example, high cost and high complexity including need of welding, riveting, crimping, high compressing force, high tuck time, or the like.

The object of the disclosed subject matter is to provide enhanced EMC means and corresponding methods of application thereof which at least partially overcome disadvantages attributable to prior art EMC means and methods.

### 3. Summary of the invention

The above-mentioned object is realized by a foam tape according to claim 1 and a method for attaching said foam tape to an electronic device according to claim 13.

Particularly, the above-mentioned object is realized by a foam tape for providing electromagnetic compatibility (EMC)-shielding. The foam tape comprises one or more elongated foam segments. As generally known to the skilled person, each elongated foam segment has a cross section and a length which is perpendicular thereto. Each elongated foam segment is contiguous at its entire cross section along its entire length. For example, the elongated foam segment is not pre-cut into individual portions, is not composed of die-cut portions partly joined together, or the like. As a result, a section of the foam tape may be attached (e.g., manually or by a robotic arm) to an electronic device and then cut off from a remaining part of the foam tape. This may advantageously enable reduction of complexity and cost since, for example, a unified foam tape (and a corresponding method of application thereof) may be used for a variety of different electronic devices. Each elongated foam segment is compressible in at least a direction which is perpendicular to the length. As a result, the foam tape may be applied to an electronic device such that the foam tape is compressed once the electronic device is assembled. This may advantageously compensate manufacturing tolerances (e.g., of a housing, a printed circuit board, or the like) and effectuate proper contact (e.g., electric contact) between the foam tape and a member of the electronic device to which the foam tape is attached. In addition, each elongated foam segment is electrically conductive in at least a direction perpendicular to the length. The direction in which each elongated foam segment is electrically conductive may be the same direction in which the respective elongated foam segment is compressible. As a result, the foam tape may be advantageously applied to an electronic device, for example, to effectuate/facilitate electric contact (at least for the purposes of EMC-shielding) between a printed circuit board and a housing or between two parts of the housing with each other which may advantageously ensure compliance with regulatory (or customer) EMC-specifications.

In an aspect of the present disclosure, the one or more elongated foam segments are carried by a release liner. The release liner may be contiguous along the length of the entire foam tape or may be composed of a plurality of segments. As a result, the foam tape may be advantageously attachable to an electronic device and/or the foam tape, when composed of a plurality of elongated foam segments, may be advantageously regarded as mechanically contiguous for the purpose of being applied to an electronic device.

In an aspect of the present disclosure, the length of each elongated foam segment is at least 250 mm. As a result, a limited number of individual elongated foam segments may be advantageously required to be connected to form a foam tape. Preferably the length of each elongated foam segment is at least 500 mm (and more preferably at least 1000 mm). As a result, even more limited number of individual elongated foam segments may be advantageously required to be connected to form a foam tape.

In an aspect of the present disclosure, the foam tape comprises a plurality of elongated foam segments defined in accordance with any of one of the aspects in accordance with the present disclosure. Adjacent elongated foam segments of the plurality of foam segments are connected by a segment of the release liner. As a result, both the foam and the release liner may be advantageously segmented to facilitate manufacturing and may be advantageously connected to form a foam tape which is regarded as mechanically contiguous for the purpose of being applied to an electronic device.

In an aspect of the present disclosure, a gap between the adjacent elongated foam segments (each gap between respective adjacent elongated foam segments within the foam tape) is at most 1,5 mm. As a result, the foam tape may be regarded as contiguous for the purpose of providing EMC-shielding to electronic devices. Preferably the gap between the adjacent elongated foam tape segments is at most 1,0 mm (and more preferably at most 0,5 mm). As a result, the foam tape may be regarded as contiguous for the purpose of providing EMC-shielding even at higher frequencies. In an aspect of the present disclosure, a gap between adjacent segments of the release liner (each gap between respective adjacent segments of the release liner within the foam tape) is at most 1,5 mm. As a result, the foam tape may be regarded as mechanically contiguous for the purpose of being applied to an electronic device. Preferably the gap between the adjacent segments of the release liner is at most 1,0 mm (and more preferably at most 0,5 mm). As a result, the foam tape may be regarded as mechanically contiguous for the purpose of being applied to even smaller features of an electronic device.

In an aspect of the present disclosure, a ratio of the length to a maximal dimension within the cross section (e.g., a width of each elongated foam segment, a thickness of each elongated foam segment) is at least 100. As a result, the foam tape is elongated and may advantageously be applied to a plurality of members of an electronic device or to a plurality of electronic devices by cutting off respective sections of the foam tape. Preferably the ratio is at least 500 which results in a longer foam tape. As a result, the foam tape may be advantageously applied to a greater number of members and/or electronic devices, for example, without need of installing another foam tape into a manual or automated application means (e.g., a dispensing tool, a robotic arm, or the like). More preferably the ratio is at least 1000 (most preferably at least 5000) which results in a yet longer foam tape and may advantageously reduce frequent installing another foam tape into the application means.

In a further aspect of the present disclosure, the cross section is uniform along the entire length of the foam tape. As a result, the foam tape may be advantageously used for unification of EMC means including use of the same foam tape and the same application means for multiple products. In another aspect of the present disclosure, the cross section varies (preferably stepwise) along the length of the foam tape. As a result, the foam tape may be advantageously adapted to match EMC specifications which may vary for different members of an electronic device and, for example, may result in a different thickness and/or width of the foam tape for individual members.

In a further aspect of the present disclosure, the foam tape has, in its uncompressed state, a thickness of 1 to 10 mm. As a result, upon being compressed (in the direction in which the foam tape is compressible), the foam tape may advantageously compensate manufacturing tolerances and effectuate proper contact between the foam tape and a member of the electronic device to which the foam tape is attached. Preferably the thickness is 1 to 7 mm which results in a thinner foam tape and may advantageously reduce weight and cost as well as improve mechanical stability. More preferably the thickness is 1 to 5 mm (most preferably 1 to 3 mm) which results in a yet thinner foam tape and may advantageously reduce weigh and cost as well as improve mechanical stability. In some aspects of the present disclosure, the thickness may be substantially constant along the entire length of the foam tape.

In a further aspect of the present disclosure, each elongated foam segment is associated with an adhesive layer on at least a part of its surface (e.g., at one entire surface or at a part of one surface) preferably along substantially the entire length of the respective elongated foam segment. In some aspects of the present disclosure, the adhesive layer may be covered by a release liner. As a result, the foam tape may be advantageously attachable to an electronic device. Still, the foam tape may not comprise an adhesive layer/feature as, for example, such foam tape may be advantageously clutched in a designated securing groove of an electronic device.

In a further aspect of the present disclosure, each elongated foam segment is electrically conductive in at least one further direction and preferably exhibits substantially isotropic electric conductivity. As a result, the foam tape may advantageously provide enhanced EMC-shielding and/or thermal conductivity.

In a further aspect of the present disclosure, the foam tape is rolled preferably on a tube-shaped member or on a spool. As a result, the foam tape may be advantageously suitable for installing in a dispensing tool such as a hand tool or a in a robotic arm.

In a further aspect of the present disclosure, the cross section is substantially rectangular. As a result, the foam tape may be advantageously used for unification of EMC means since a substantially rectangular cross section may be suitable for many products.

In a further aspect of the present disclosure, the foam tape is compressible, relative to its uncompressed state, in a range of 5 to 90 %. As a result, upon being compressed, the foam tape may advantageously compensate manufacturing tolerances and effectuate proper contact between the foam tape and member(s) of the electronic device to which the foam tape is attached. Preferably the foam tape is compressible in the range of 10 to 70 % which results in a stiffer foam tape and may advantageously improve mechanical stability. More preferably the foam tape is compressible in the range of 10 to 50 % (most preferably 30 to 40 %) which results in a yet stiffer foam tape and may advantageously improve mechanical stability.

In a further aspect of the present disclosure, dimensions of the cross section are such that, after compression within the range, an aspect ratio of the cross section of up to 1:1 is achievable. As a result, the foam tape may be advantageously used for unification of EMC means since an aspect ratio of up to 1:1 may be suitable for many products.

In a further aspect of the present disclosure, the electric conductivity is at least 1 S/m and preferably 3 S/m. In a yet further aspect of the present disclosure, each elongated foam segment is made of an elastic material (e.g., a modified elastic material) and preferably of polyurethane or low-density polyethylene. As a result, compliance with EMC specifications may be advantageously ensured.

Further particularly, the above-mentioned object is realized by a method of attaching the above-described foam tape to an electronic device to provide EMC-shielding. A first section of the foam tape is applied (e.g., adhered to a designated area, for example, by removing the release liner or applying an adhesive, inserted into a groove or into a form-fit means, or the like) to a first member of the electronic device (e.g., to a printed circuit board, to a part of a housing, or the like). The applied section is then cut off from a remaining part of the foam tape to remain at the first member of the electronic device. The steps of applying and cutting off may be subsequently repeated to apply further section(s) of the foam tape to further member(s) of the electronic device. As a result, unification of EMC means may be advantageously achieved.

In an aspect of the present disclosure, pressure is applied to the first section of the foam tape (e.g., to the section applied to the first member of the electronic device). Preferably the pressure is such that, when the foam tape is compressed by the pressure,
a thickness of the foam tape is in a range of 30 to 90 % of a thickness of the foam tape in its uncompressed state. As a result, the adhesive layer of the foam tape may be advantageously activated.

In a further aspect of the present disclosure, the above-described method steps are performed manually. As a result, EMC-shielding may be advantageously provided without need of using automated - and hence typically more complex - means. In another aspect of the present disclosure, the above-described method steps are performed by a robotic arm. As a result, EMC-shielding may be advantageously provided in time efficient and reproducible manner.

### 4. Brief description of the drawings

In the following, various aspects of the disclosed subject matter are described in detail with reference to the accompanying figures, in which:
- Fig. 1A: shows schematically an embodiment of a foam tape comprising one elongated foam segment;
- Fig. 1B: shows schematically an embodiment of a foam tape comprising a plurality of elongated foam segments;
- Fig. 2: shows a schematically an embodiment of a method of attaching a foam tape to an electronic device;
- Fig. 3A: shows a three-dimensional view of an embodiment of a robotic manipulator;
- Fig. 3B: shows a side view of a portion of the embodiment of the robotic manipulator;
- Fig. 4: shows a three-dimensional view of an embodiment of a die-cast cover.

### 5. Detailed description

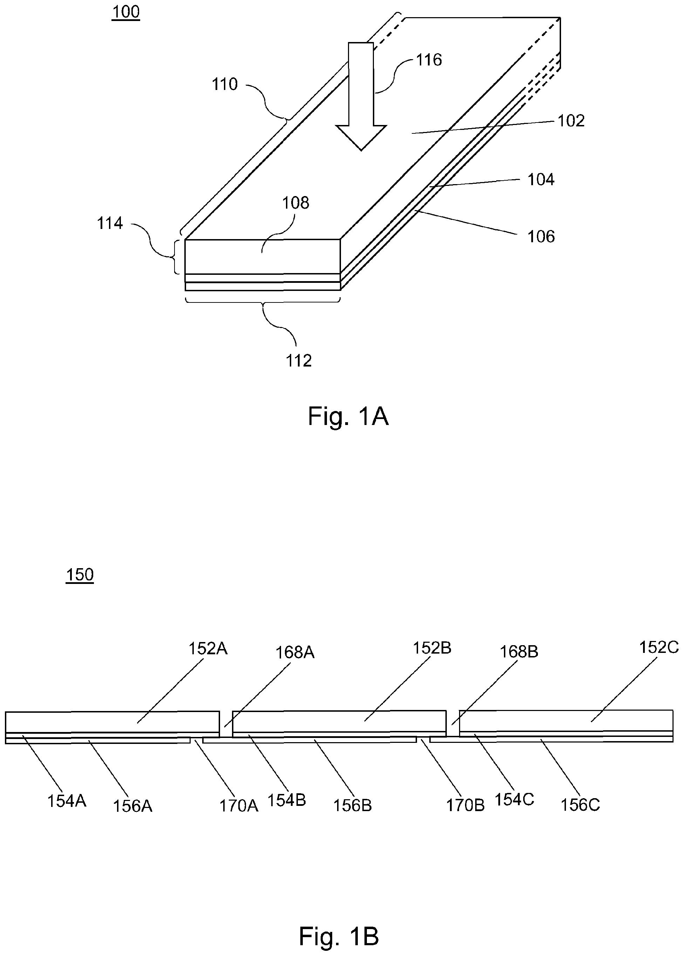

Fig. 1A shows - schematically - a foam tape 100 according to an embodiment of the present disclosure. The foam tape 100 comprises an elongated foam segment 102, an adhesive layer 104 arranged on one surface of the elongated foam segment 102 and a release liner 106 covering the adhesive layer 104. The elongated foam segment has a cross section 108 and a length 110. The cross section 108 is formed by a width 112 and a thickness 114. The elongated foam segment 102 is contiguous (i.e., not pre-cut into individual portions, not composed of die-cut portion partly jointed together, or the like) along its entire length 110. In general, the length 110 may assume various ratios relative to the width 112 and/or the thickness 114 - this aspect is illustrated by dashed lines along the length 110. The length 110 may be equal to 250 mm, however, also greater values of the length 110 are envisaged. The elongated foam segment 102 is made of a (modified) elastic material (e.g., polyurethane or low-density polyethylene). The foam tape 100 is compressible in a direction indicated by an arrow 116. The direction indicated by the arrow 116 is perpendicular to the length 110. Furthermore, the foam tape 100 (the elongated foam segment 102 and/or the adhesive layer 104) is electrically conductive in the direction indicated by the arrow 116. The electric conductivity may equal to at least 3 S/m, however, smaller values of the electric conductivity are also envisaged.

Fig. 1B shows - schematically - a foam tape 150 according to an embodiment of the present disclosure. The foam tape 150 comprises a plurality of elongated foam segments 152A, 152B and 152C, each of which substantially corresponds to the elongated foam segment 102 explained in conjunction with Fig. 1A above. Accordingly, for example, the elongated foam segments 152A, 152B and 152C have respective adhesive layers 154A, 154B and 154C. The elongated foam segments 152A, 152B and 152C are spaced apart by gaps 168A and 168B. The gaps 168A and 168B may have a length of at most 1,5 mm, however, smaller values are also envisaged. Adjacent elongated foam segments (e.g., the elongated foam segments 152A and 152B, or the elongated foam segments 152B and 152C) are connected by respective a respective segment 156A, 156B and 156C of a release liner. The segments 156A, 156B and 156C of the release liner are spaced apart by gaps 170A and 170B. The gaps 170A and 170B may have a length of at most 1,5 mm, however, smaller values are also envisaged. In an aspect (not shown in Fig. 1B), the release liner may be contiguous along substantially the entire length of the foam tape 150 (i.e., the gaps 170A and 170B may not be present). In an aspect (not shown in Fig. 1B), the adjacent elongated foam segments 152A, 152B and 152C may be connected (e.g., glued) at respective ends without the use of a release liner for connecting the elongated foam segments 152A, 152B and 152C. Mechanical and electrical properties of the elongated foam segments 152A, 152B and 152C may substantially correspond to respective mechanical and electrical properties of the elongated foam segment 102 explained in conjunction with Fig. 1A above.

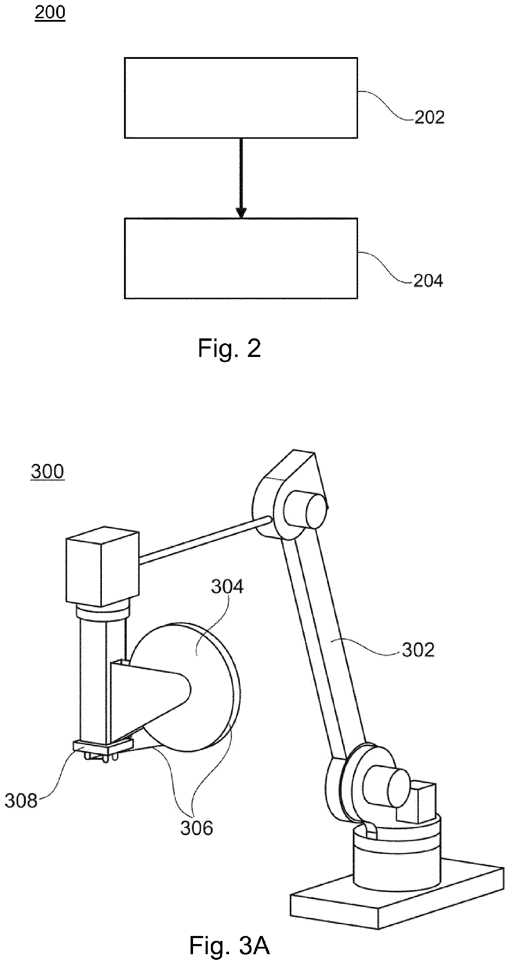

Fig. 2 shows - schematically - a block diagram 200 of a method of attaching a foam tape to an electronic device to provide EMC-shielding according to an embodiment of the present disclosure - the foam tape being in accordance with any of the aspects of the present disclosure. The method 200 comprises the step 202 of applying a first section of the foam tape to a first member of the electronic device and the step 204 of cutting off the first section from a remaining part of the foam tape. The steps 202 and 204 may be subsequently repeated (not shown) to apply further section(s) of the foam tape to further member(s) of the electronic device.

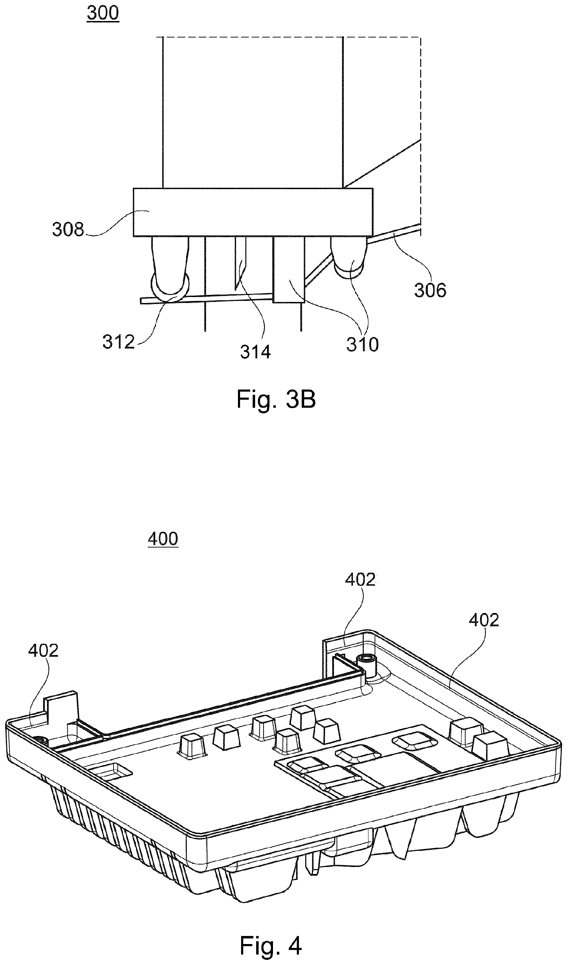

Fig. 3A shows - in a three-dimensional view - a robotic manipulator 300 comprising a robotic arm 302, a spool 304 having a foam tape 306 rolled thereon and a head 308 according to an embodiment of the present disclosure. The foam tape 306 may be a foam tape in accordance with any of the aspects of the present disclosure. The robotic manipulator 300 is configured to apply a section of the foam tape 306 to a member of an electronic device (not shown) directly from the spool 304 by, for instance, adhering it to a designated area of the member, for example, by removing the release liner or applying an adhesive, inserting the foam tape 306 into a groove or into a form-fit means, onto doghouse top, envelope around a housing of the electronic device, or the like. The head 308 may be equipped with localization means (e.g., laser, camera, mechanical contact probes, or the like) to enable the section of the foam tape 306 to be properly placed onto the designated area of the electronic device (not shown). In addition, the head 308 is equipped with guidance members, a compressing roll and a cutting means (the three of which are explained in conjunction with Fig. 3B).

Fig. 3B shows - in a side view - a portion of the robotic manipulator 300 including the head 308 according to an embodiment of the present disclosure. The head 308 is equipped with a guidance 310 configured to guide the foam tape 306 from the spool 304 (not shown in Fig. 3B but shown in Fig. 3A) to the designated area of the electronic device (not shown). The head 308 is further equipped with a compressing roll 312 configured to apply pressure to the section of the foam tape 306 applied onto the designated area of the electronic device (not shown), for example, after initial placing the section onto the designated area, in order to active the adhesive layer of the foam tape 306 (e.g., the adhesive layer 104, 154A, 154B and 154C explained in conjunction with Figs. 1A and 1B). In addition, the head 308 may be equipped with means to remove a release liner from the foam tape 306 (e.g., the release liner 106, 156A, 156B and 156C explained in conjunction with Figs. 1A and 1B). The head 308 is moreover equipped with cutting means 314 (e.g., a guillotine, a roll knife, or the like) configured to separate (e.g., cut off) the section of the foam tape 306 already applied to the designated area from the remaining part of the foam tape 306. In some aspects of the present disclosure, the head 308 may be used aside of robotic means as a hand tool for the purpose of applying the foam tape 306.

Fig. 4 shows - in a three-dimensional view - a die-cast cover 400 of a housing of an electronic device according to an embodiment of the present disclosure. The die-cast cover comprises flat lips 402 configured as a designated area for application of a foam tape (not shown). The foam tape may be a foam tape in accordance with any of the aspects of the present disclosure.

### List of reference signs:

- 100: foam tape
- 102: elongated foam segment
- 104: adhesive layer
- 106: release liner
- 108: cross section
- 110: length
- 112: width
- 114: thickness
- 116: compression direction

- 150: foam tape
- 152A, 152B, 152C: elongated foam segment
- 154A, 154B, 154C: adhesive layer
- 168A, 168B: gap between elongated foam segments
- 170A, 170B: gap between segments of release liner
- 200: block diagram
- 202: applying foam tape
- 204: cutting off foam tape

- 300: robotic manipulator
- 302: robotic arm
- 304: spool
- 306: foam tape
- 308: head
- 310: guidance
- 312: compressing roll
- 314: cutting means

- 400: die-cast cover
- 402: flat lips

## Claims

1. A foam tape (100, 150) for providing EMC-shielding to electronic devices,
a. wherein the foam tape (100, 150) comprises one or more elongated foam segments (102, 152A, 152B, 152C), each elongated foam segment (102, 152A, 152B, 152C) having a cross section (108) and a length (110);
b. wherein each elongated foam segment (102, 152A, 152B, 152C) is compressible in at least a direction (116) perpendicular to the length (110); and
c. wherein each elongated foam segment (102, 152A, 152B, 152C) is electrically conductive in at least a direction (116) perpendicular to the length (110).

2. The foam tape (100, 150) of claim 1, wherein the one or more elongated foam segments (102, 152A, 152B, 152C) are carried by a release liner (106, 156A, 156B, 156C).

3. The foam tape (100, 150) of any of the preceding claims, wherein the length (110) of each elongated foam segment (102, 152A, 152B, 152C) is at least 250 mm, preferably at least 500 mm and more preferably 1000 mm.

4. The foam tape (150) of any of the preceding claims, wherein the foam tape (150) comprises a plurality of elongated foam segments (152A, 152B, 152C) defined in accordance with any of the preceding claims, wherein adjacent elongated foam segments of the plurality of foam segments (152A, 152B, 152C) are connected by a segment of the release liner (156A, 156B, 156C).

5. The foam tape (150) of any of the preceding claims, wherein a gap (168A, 168B) between the adjacent elongated foam segments (152A, 152B, 152C) is at most 1,5 mm, preferably at most 1,0 mm and more preferably at most 0,5 mm and/or wherein a gap (170A, 170B) between adjacent segments of the release liner (156A, 156B, 156C) is at most 1,5 mm, preferably at most 1,0 mm and more preferably at most 0,5 mm.

6. The foam tape (100, 150) of claim 1, wherein a ratio of the length (110) to a maximal dimension within the cross section (108) is at least 100, preferably at least 500, more preferably at least 1000 and most preferably at least 5000.

7. The foam tape (100, 150) of any of the preceding claims, wherein the foam tape (100, 150) has, in its uncompressed state, a thickness of 1 to 10 mm, preferably 1 to 7 mm, more preferably 1 to 5 mm and most preferably 1 to 3 mm.

8. The foam tape (100, 150) of any of the preceding claims in combination with claim 2, wherein each elongated foam segment (102, 152A, 152B, 152C) is associated with an adhesive layer (104, 154A, 154B, 154C) on at least a part of its surface preferably along substantially the entire length (110).

9. The foam tape (100, 150) of any of the preceding claims, wherein each elongated foam segment (102, 152A, 152B, 152C) is electrically conductive in at least one further direction, and preferably wherein each elongated foam segment (102, 152A, 152B, 152C) exhibits substantially isotropic electric conductivity.

10. The foam tape (100, 150) of any of the preceding claims, wherein the foam tape (100, 150) is rolled preferably on a tube-shaped member or on a spool.

11. The foam tape (100, 150) of any of the preceding claims, wherein the foam tape (100, 150) is, relative to its uncompressed state, compressible in a range of 5 to 90 %, preferably 10 to 70 %, more preferably 10 to 50 % and most preferably 30 to 40 %, and preferably wherein dimensions of the cross section (108) are such that, after compression within the range, an aspect ratio of the cross section of up to 1:1 is achievable.

12. The foam tape (100, 150) of any of the preceding claims, wherein the electric conductivity is at least 1 S/m and preferably at least 3 S/m and/or wherein each elongated foam segment (102, 152A, 152B, 152C) is made of an elastic material and preferably is made of polyurethane or low-density polyethylene.

13. A method (200) of attaching the foam tape (100, 150) of any of the preceding claims to an electronic device to provide EMC-shielding, the method (200) comprising:
applying (202) a first section of the foam tape (100, 150) to a first member of the electronic device; and
cutting off (204) the first section from a remaining part of the foam tape.

14. The method (200) of claim 13, further comprising:
applying pressure to the first section of the foam tape (100, 150), preferably wherein the pressure is such that, when the foam tape (100, 150) is compressed by the pressure, a thickness (114) of the foam tape (100, 150) is in a range of 30 to 90 % of a thickness (114) of the foam tape (100, 150) in its uncompressed state.

15. The method (200) of any of claims 13 to 14, wherein the method steps are performed either manually or by a robotic arm (302).
